# EUROPEAN PATENT APPLICATION

(11) **EP 1 460 687 A1**
(43) Date of publication of application: **22.09.2004**
(21) Application number: 04101124.8
(22) Date of filing: 18.03.2004
(51) Int. Cl.: H01L 23/13, H01L 23/498

(54) **Recessed Wire Bonded Semiconductor Package Substrate**

(30) Priority: 21.03.2003 US 456708 P; 14.11.2003 US 714285
(71) Applicant: Texas Instruments Inc., Dallas, Texas 75265 (US)
(72) Inventor: Hortaleza, Edgardo R., 75044, Garland (US); Howard, Gregory E., 75229, Dallas (US)
(74) Representative: Holt, Michael

(57) **Abstract**

A semiconductor package substrate (320) including a plurality of dielectric layers (424) and a plurality of metal layers (422), wherein the metal layers (422) further include a first metal layer (440) and at least one underlying metal layer (442), and wherein the underlying metal layer (442) is configured for a di rect interconnection with a semiconductor die (410). Preferably, the top metal layer (440) includes a ground plane. An underlying metal layer (442) comprises the signal layer, which is preferably bonded to the die by a plurality of bond wires (452).

## Description

### BACKGROUND OF THE INVENTION

Integrated circuits are fabricated on the surface of a semiconductor wafer in layers and later singulated into individual semiconductor devices, or "dies." Many fabrication processes are repeated numerous times, constructing layer after layer until fabrication is complete. Metal layers (which typically increase in number as device complexity increases) include patterns of conductive material that are insulated from one another ver tically by alternating layers of insulating material. Vertical, conductive tunnels called "vias" typically pass through insulating layers to form conductive pathways between adjacent conductive patterns. Since the material of a semiconductor wafer-commonly silicon-tends to be relatively fragile and brittle, dies are often packaged in a protective housing, or "package," before they are interconnected with a printed circuit board (PCB).

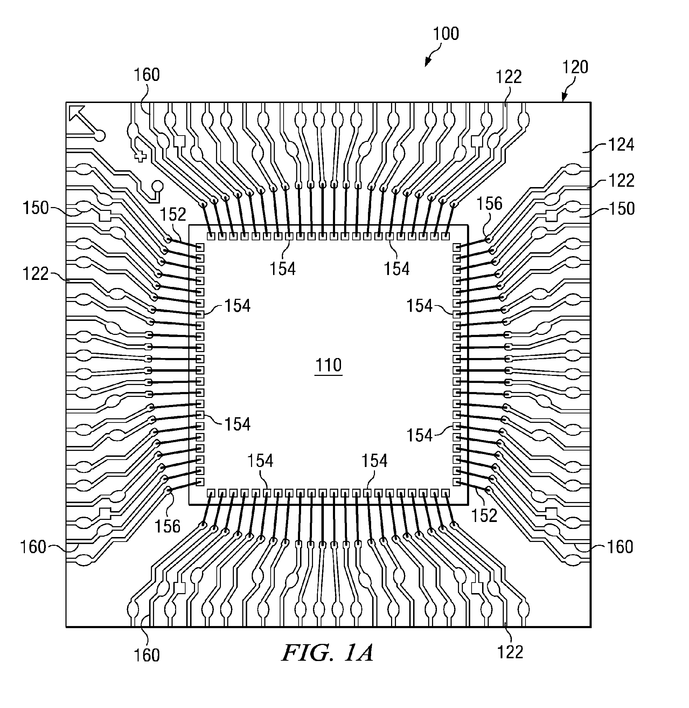

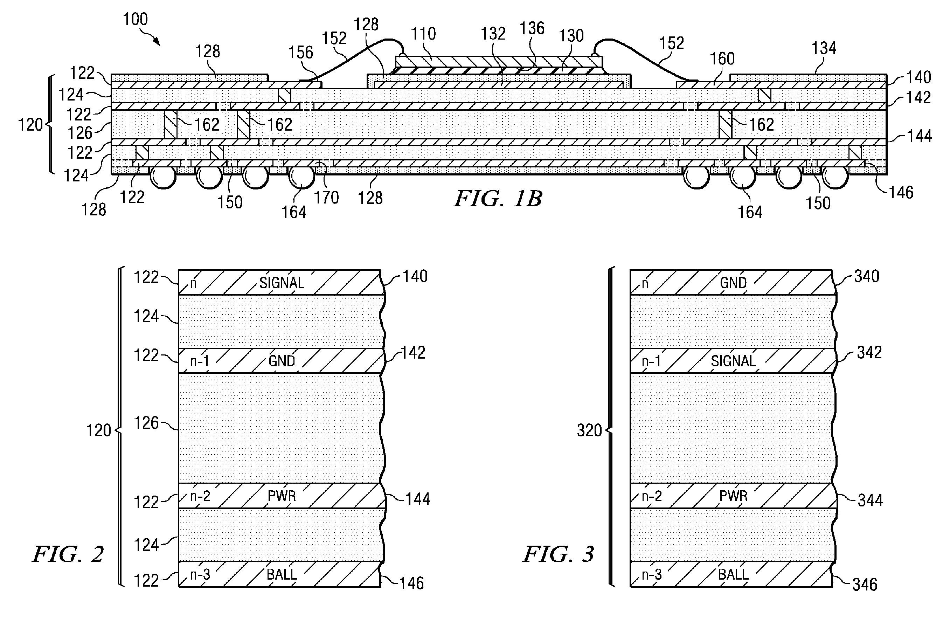

A commonly used packaging technology involves attaching a die to the surface of a package substrate, a structure for interconnecting a die to a PCB. Referring now to Figures 1A and 1B, top and cross-sectional views are shown, respectively, of a semiconductor die assembly 100 including a semiconductor die 110 assembled to an exemplary package substrate 120. It will be understood that the term "substrate" is used herein to denote a package substrate, and not the wafer surface upon which dies are fabricated, as used in fabrication terminology. Package substrates 120 are fabricated in layers, typically with alternating layers of electrically conductive metals 122 and non-conductive insulating materials 124, or "dielectrics." It will be understood that a metal layer 122 may include patterns of metal, but may also include area s of interstitial dielectric material 150, electrically insulating traces 160 and patterns of metal within a single metal layer.

In general, as shown in Figure 1B, a matched number of metal layers 122 are situated on either side of a core material 126, a thicker "backbone" layer typically comprised of the material used in the dielectric layers 124. A balanced number of metal layers 122 on either side of the core 126 contributes to less substrate warpage resulting from uneven expansion of the various subst rate layers 122 and 124 when heated. Photo-definable solder mask layers 128 typically protect the top and bottom metal layers 122 of the substrate. For clarity, the topmost solder mask layer 128 is not shown in Figure 1A. A photolithography process is t ypically used to create openings in areas of the solder mask layers 128, exposing the appropriate underlying area of metal layer 128 for interconnection.

In the exemplary configuration shown in Figure 1B, the substrate 120 has four metal layers 122, and is consequently called a "four-layer" substrate. Typically, the first metal layer (or n metal layer) 140, as counted from the substrate top, is a signal layer, to which the signals and other addresses on the die 110 are wirebonded or otherwise coupled. The die 110 is shown interconnected to the signal layer 140 with bond wires 152. Layers 142, 144 and 146 typically comprise a ground plane, power plane and ball layer, respectively. Ground plane 142 and power plane 146 often include relatively sturdy planes, or large patterns of metal less susceptible to damage than relatively narrow traces 160. Die bond pads 154 assigned to power or ground are interconnected with the power plane 142 or ground plane 146, respectively, by vias 162, cylindrical columns of conductive material for interconnecting two metal layers 122. It will be understood that power and ground metal may share the same metal layer 122, each having a unique area of metal electrically insulated from the other by an interstitial dielectric 150 or other insulating material. The ball layer metal 146 is typically configured into conductive areas, or lands 170, each attached to a solder ball 164, which may be later reflowed to a PCB, interconnecting the die 110 to the PCB.

A die attach compound 130, typically an epoxy, is dispensed over the center region, or flag 132, on the upper surface 134 of the substrate 120. The flag 132 is generally covered by the solder mask material 128, electrically insulating the back surface 136 of the die 110 from the substrate 120. The die 110 is attached to the substrate 120 by placing the die back surface 136 onto the dispensed die attach 130. The die is then electrically interconnected to the substrate 120, typically by a wirebonding process, in which bond wires 152 are stitched between a die bond pad 154 and a substrate bond pad 156. Substrate bond pads 156 may be no more than slightly widened end potions of a metal trace 160, or conductive line, as shown in Figure 1B. After wirebonding, the die is typically encapsulated by molding an encapsulant, or "mold compound" (not shown) over the die, shielding it from physical damage.

As previously mentioned, during operation or testing, the die 110 and substrate 120 may build up heat, subjecting the dissimilar layers within the package assembly 100 to mechanical stresses. Each material within the assembly 100 has a unique coefficient of thermal expansion (CTE), a physical value that denotes the tendency of a material to expand in relation to temperature increases. An important focus in packaging technology is to design packages in which the interfaces of layered materials have relatively similar CTE values. When a relatively expansive-or high-CTE-material is coupled to a less expansive -or low-CTE-material, high stresses may result at the interface of the two materials. Essentially, the more expansive material will apply a tensile force along the surface of the less expansive material, trying to stretch the low -CTE surface. This tensile force can crack, rip or otherwise damage sensitive features or components on or near the surface.

Table 1 below shows approximate values for several materials commonly used in assembling a packaged semiconductor device, as shown in Figures 1A and 1B. The silicon die has a very low CTE (about 3 ppm/C), compared to the CTE of a typical organic substrate material, such as bismaleimide triazine (BT), of about 50 ppm/C. High-CTE substrates often incur mechanical damage when coupled to low-CTE dies. Traces 160 may be less than 1 -mil (about 25 microns) thick. As shown in Figure 1B, traces 160 have historically been located on the top metal layer 140. The tendency of the die 110 to constrict expansion of substrate surface 134 and the immediately underlying layers may cause destructive force s within these delicate traces 160.

**Table 1.**

| **Material Properties** **Directionally dependent on alignment of Si crystals* | |
|---|---|
| | **CTE (ppm/C)** |
| **Si** | 2.4-3.0 |
| **BT** | 50 |
| **Cu** | 16-17 |
| **Die attach** | 30 |
| **Mold compound** | 54 |

The presence of the die 110 does not allow mechanical stresses to be sufficiently dispersed over the substrate upper surface 134. As the metal traces 160 are stretched by the expansive substrate 120, they are also held in place by the die 110 in certain areas. This uneven distribution of force can crack o r sever the traces 160, resulting in a faulty or inoperable semiconductor device. Routing underneath the die can also be torn apart.

Figure 2 is a partial cross-sectional view of a simplified version of Figure 1B, with like parts having like reference numerals. As shown in Figure 1B, in a typical configuration, top metal layer, or *n* metal layer 140, includes a signal metal layer. The second metal layer, or *n-1* layer 142, as counted from the top includes a ground plane. The third metal layer, or *n-2* layer 144, includes a power plane. The fourth metal layer, or *n-3* layer 146, includes a land metal plane, which may include "lands," or conductive areas with which an interconnector (e.g., a solder ball or spring) may be contacted to produce electrical inte rconnection with a PCB.

As previously discussed, disposing a signal metal layer on the *n* metal layer may subject relatively fragile signal traces to excessive mechanical stresses. Generally, the further a component is away from an interface with a large CTE mismatch, the less mechanical stresses are incident on the component from the CTE mismatch. It is therefore desired to design a substrate such that mechanical stress impact is lessened to the critical signal traces with minimal impact to other metal layers.

### BRIEF SUMMARY OF THE INVENTION

Disclosed are a recessed-bond semiconductor package substrate and a method for assembling a semiconductor die onto the substrate. The recessed-bonded substrate includes a plurality of dielectric layers and a plurality of metal layers. The metal layers further include a first metal layer and at least one underlying metal layer configured for a direct interconnection with a semiconductor die. The underlying metal layer includes a signal layer. In a preferred embodiment, the top metal layer includes a ground plane. The signal layer is preferably bonded to the die by a plurality of bond wires.

### BRIEF DESCRIPTION OF THE DRAWINGS

For a detailed description of the preferred embodiments of the invention, reference will now be made to the accompanying drawings in which:
Figure 1A is a top view of a semiconductor die assembled to an exemplary package substrate;
Figure 1B is a cross-sectional view of Figure 1A;
Figure 2 is a partial cross-sectional view of a simplified version of Figure 1B;
Figure 3 is a simplified partial cross-section view of a semiconductor package substrate in accordance with a preferred embodiment;
Figure 4 is a cross-sectional view of a semiconductor die assembled to the exemplary package substrat e shown in Figure 3;
Figure 5 is a simplified top view of the preferred embodiment shown in Figure 4; and
Figure 6 is a simplified top view of an alternative embodiment.

### NOTATION AND NOMENCLATURE

Certain terms are used throughout the following descript ion and claims to refer to particular system components. As one skilled in the art will appreciate, companies may refer to a component by different names. This document does not intend to distinguish between components that differ in name but not function. In the following discussion and in the claims, the terms "including" and "comprising" are used in an open-ended fashion, and thus should be interpreted to mean "including, but not limited to...". Also, the term "couple" or "couples" is intended to mean either an indirect or direct electrical connection. Thus, if a first device couples to a second device, that connection may be through a direct electrical connection, or through an indirect electrical connection via other devices and connections.

The term "integrated circuit" refers to a set of electronic components and their interconnections (internal electrical circuit elements, collectively) that are patterned on the surface of a microchip. The term "semiconductor device" refers generically to an integrated circuit (IC). The term "die" ("dies" for plural) refers generically to an integrated circuit, in various stages of completion, including the underlying semiconductor substrate and all circuitry patterned thereon. The term "wafer" refers to a gener ally round, single-crystal semiconductor substrate upon which integrated circuits are fabricated in the form of dies. The term "interconnect" refers to a physical connection providing possible electrical communication between the connected items. The ter m "bumped die" is used herein to indicate an integrated circuit die with controlled collapse chip connection (C4) or current state -of-the-art conductive bumps patterned thereon, for interconnection with a substrate, printed circuit board or other electrical component. The term "flip chip" refers to such a bumped die, which is designed for a face-down direct interconnection with an underlying electrical component through the C4 or bumped connection. The terms "direct interconnection" and "directly connected" are used herein to indicate a physical, electrically conductive connection in which two components (e.g., a die and a package substrate layer) are electrically interconnected by a conductive interface (e.g., a bond wire), and wherein the conductive interface directly contacts the two components.

The term "substrate" is used herein to denote a package substrate, and not the wafer surface upon which die are fabricated, as used in fabrication terminology. The term "semiconductor package" refers generically to the components for encapsulating and interconnecting a die to a printed circuit board, and is used herein to include an LGA substrate and lid. The term "packaged semiconductor device" refers to a die mounted within a package, as well as all package constituent components. The term "semiconductor die assembly" is used herein to a die and its associated package components, generally in an incomplete state of package assembly. To the extent that any term is not specially defined in this specification, the intent is that the term is to be given its plain and ordinary meaning.

### DETAILED DESCRIPTION OF THE PREFERRED EMBODIMENTS

Figure 3 shows a simplified view of a partial cross -section of a recessed-bond semiconductor package substrate 320 in accordanc e with a preferred embodiment. A top metal layer, or *n* metal layer 340, preferably includes a ground plane. A second metal layer, or *n-1* layer 342, as counted from the top, preferably includes a signal layer. While the top metal layer is denoted as the *n* layer, a subsequent (or underlying) metal layer is denoted as an *n-k* layer, where *k* represents the number of metal layers a particular metal layer is removed from the *n* layer. It will be understood that this nomenclature is independent of the total numbe r of metal layers within a substrate. A third metal layer, or *n-2* layer 344, preferably includes a power plane, and a fourth metal layer, or *n-3* layer 346, preferably includes a land plane. "Lands" are conductive areas with which an interconnector (e.g., a solder ball or spring) may be contacted to produce electrical interconnection with a PCB. Disposing the signal layer on the *n-1* metal layer 342 adds physical support to the relatively fragile signal traces. Instead of being disposed on the outermost (i.e., *n* metal) layer 340, in the preferred embodiment, the signal layer is layered underneath at least one metal layer, shielding it from higher CTE -mismatch forces possible within the *n* metal layer.

It will be understood that orientation comments relating to the position of the metal layers within the package substrate are with respect to the die mounted on the substrate. For example, referencing an *n-1* layer as located "below" an *n* metal layer will indicate that the *n-1* layer is disposed farther removed from the die than is the *n* metal layer. The top metal layer of a substrate, or closest metal layer to the die is the n metal layer, with each underlying layer denoted as *n-1, n-2, n-3,* etc.

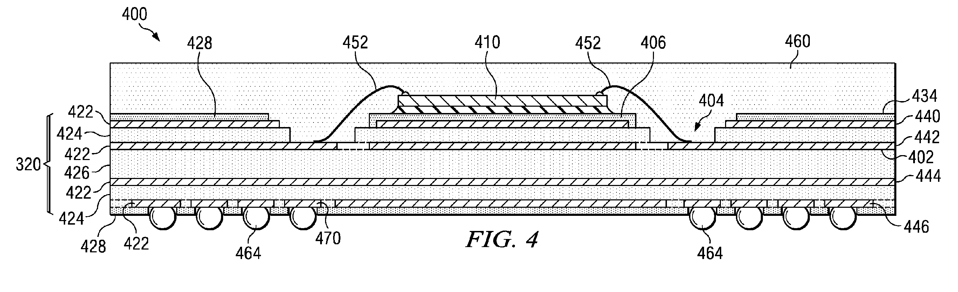

Figure 4 shows a more detailed view of the substrate 320 shown in Figure 3, configured with a semiconductor package assembly 400. Instead of positioning the signal metal 402 on the *n* metal layer 440, as with conventional substrate designs, the signal layer is positioned below the *n* metal layer within the substrate. Bond wires 452 pass through a substrate bond opening 404 in the solder mask layer 428, *n* metal layer 440, and a first dielectric layer 424 to connect the signal metal 402 disposed on the *n-1* metal layer 442 to an integrated circuit, or semiconductor, die 4 10. The recessed-bond substrate is so named because the metal layer to which the die is directly interconnected is recessed below the top metal layer 440. The substrate bond openings 404 in the solder mask layer 428, *n* metal layer 440, and the dielectric layer 424 may be created using any method known in the art, including photolithography and etching processes. It will be understood that, while the preferred embodiment shown in Figure 4 illustrates a signal layer 402 disposed on the *n-1* layer 442, the signal layer may be disposed on a subsequent metal layer 422 (e.g., n-2 layer 444, n-3 layer 446).

After wirebonding, the die 410 may be encased in an encapsulant 460, which is preferably a mold compound or epoxy shielding the die and at least a portion of the upper substrate surface 434 from the outside environment, although a lid may be used. Solder balls 464 are then preferably attached to electrically conductive lands 470 disposed on the *n-3* layer 446. Conductive lands 470 are preferably solder ball pads, including copper and nickel with a gold plating. It will be understood that, while a ball grid array (BGA) configuration has been shown, the substrate 320 of the preferred embodiments may be configured with any suitable interconnection pattern for connection with a printed circuit board (PCB), such as a land grid array (LGA) or leadless connection.

In a typical configuration, a semiconductor package assembly may heat up during operation. The various materials may consequently expand at differing rates. In particular, a more expansive substrate dielectric material (e.g., bismaleimide triazine (BT) with a CTE of about 50 ppm/C), may stretch the less expansive metal layers (e.g., copper with a CTE of about 17 ppm/C) within a substrate. This CTE mismatch may apply particular stress on the metal layer closest to the die (i.e., the *n* metal layer). In turn, the upper layers of the substrate are somewhat restricted from expanding by their attachment to the low-CTE die (e.g., silicon with a CTE of about 3 ppm/C), resulting in relatively high stresses in the die.

Attaching two materials with significantly different CTE's to one another and subjecting the structure to a temperature increase may result in relatively high stresses at the interface of the two materials and in the materials themselves. These resulting material stresses may be high enough to crack or otherwise damage the materials. By locating the signal layer of a semiconductor package substrate 320 on the *n-1* layer 442 or below, the signal layer gains additional shielding from these material stresses which may propagate from the die-substrate interface 406. Referring briefly back to Figure 1B, in a conventional substrate, the only substrate material between the die 110 and the delicate sign al layer 140 may be a relatively thin, photo-definable solder mask layer 128.

In the preferred embodiment shown in Figure 4, the signal layer metal 402 is disposed on the *n-1* layer 442 and shielded from the die 410 by a dielectric layer 424, a metal layer (e.g., a ground plane) 440, and the solder mask layer 428. By allowing the placement of a larger plane of metal (e.g., a copper ground plane with a CTE of about 17 ppm/C) within the *n* metal layer 440, the preferred embodiment lowers the effective CTE of this layer by reducing the amount of interstitial substrate material (e.g., BT with a CTE of about 50 ppm/C) present in the layer. Increasing the metal and decreasing the amount of substrate dielectric material within the layer brings the *n* metal layer 440 more in line with the CTE of the adjacent silicon die 410, which generally has a CTE of about 3 ppm/C. The possibility of lowering the effective CTE of the *n* metal layer 440 decreases the likelihood of delamination at the die-substrate interface 406.

The *n-1* signal layer location of the preferred embodiment protects the comparatively fragile signal metal 402 from the greater stresses occurring at the die-substrate interface 406 above. Essentially, these delicate circuit traces comprising the signal layer 402 are protected from breaking at junctions or at the stress concentration points inherent in the linearity discontinuities that may be present in their shapes. Referring briefly back to Figure 1A, signal traces 160 are typically designed as straigh t lines with sharp intersections, or corners. These sharp corners may serve as stress concentration points, and as such, are especially susceptible to mechanical damage from material stresses. Positioning the signal traces farther away from areas of greater material stress, in accordance with the preferred embodiments, may add to the structural integrity of these traces, which may often be critical to the performance of the semiconductor package assembly.

Electrical benefits can also be obtained by placing the signal layer metal 402 below the *n* metal layer 440 of the substrate 320. When electrical signals propagate with different velocities at various frequencies, the result is called dispersion. Dispersion is generally a result of different electromagn etic field configurations, which may result from the different frequencies involved in a signal. For a typical high -speed signal with a rise time of about 35 picoseconds (ps), the frequency content of the digital pulse may be about 20 Gigahertz (GHz). Di spersion may likely cause the rise time and system noise to increase. Rise time is typically defined as the time required for a signal to change from a specified low value to a specified high value. Faster rise times contribute to faster electronic devic es, and as such, reducing rise times is generally desired. System noise may be defined as a disturbance that affects a signal and that may distort the information carried by a signal. Keeping system noise to a minimum is also desired.

The sources of dispersion typically are changes in electromagnetic field configuration with frequency. When an electrical trace is disposed between two materials with different dielectric constants, (e.g., BT, with a dielectric constant of about 5, and mold compound, with a dielectric constant of about 3.9), the electromagnetic field propagates through each dielectric with different velocities. As the frequency changes, the electromagnetic field structure also changes, such that the effective dielectric constant becomes a function of frequency. It can be said that the velocity of propagation is frequency -dependent, and dispersion results. Consequently, it is desired to dispose an electrical trace between two similar materials to lessen the effects of dispersion. Accordingly, sandwiching a signal layer 402 (as in Figure 4) between two similar materials (e.g., dielectric layer 424 and dielectric core layer 426) in accordance with preferred embodiments may reduce dispersion, rise time and signal noise. The preferred embodiments can also be described as disposing the signal metal 402 underneath at least one dielectric layer 424, such that the signal metal is sandwiched by two adjacent, similar materials (e.g. BT dielectric).

Additionally, by placing the signal layer metal 40 2 on the *n-1* layer 442 of the package, there will normally be two full plane layers (e.g., a ground plane 440 and a power plane 444) on either side of the signal layer. This configuration increases the capacitance to the signal layer 442, making it much easier to achieve desired impedances with narrower signal traces. In addition, much finer pitches (or closer spacing) for signal traces may be allowed, while still retaining the desired impedance levels. Further, the presence of the top ground layer 440 above the signal layer 442 acts as a natural ground for the bond wires 452, providing a clean return path for high-frequency signals. The overall effect may be a lowering of the inductance of these bond wires 452.

Disposing a ground plane on the *n* metal layer 440 may reduce the radiation emanating from the package by reducing the overall length of the signal path that is open to radiation to the length of the bond wire 452. As the majority of the signal metal 402 on *n-1* layer 442 may be shielded by the overlying n metal layer 440, less radiation may be able to propagate from the signal metal. Radiation efficiency from the edge of a plane, such as the edge of *n-1* layer 442 exposed on the outer edge of substrate 320, is much less than that from an exposed printed circuit trace. By reducing the overall length of the exposed trace to that of the bond wire 452 alone, the radiation is reduced by a factor proportional to the square of the length of the exposed trace.

Disposing a ground plane on the *n* metal layer 440 may also offer the possibility of eliminating vias to the top surface of the substrate 320. Referring briefly back to Figure 1B, in a typical configuration, the bond wires 152 are bonded directly to the top, n metal layer 140 and must follow via 1 62 to the *n-1* layer 142. As shown in Figure 4, in a substrate in accordance with the preferred embodiments, bond wires 452 are bonded directly to the *n-1* layer 442, eliminating the need for a via to reach this layer. The elimination of this layer of vias may contribute to significant package cost savings while still allowing good routability. Eliminating vias from the n metal layer 440 to the signal metal 402 may contribute to a "clean" ground plane 440, meaning that via holes would not need to be created through the ground metal, interrupting the plane. A clean ground plane may be electrically preferable for high-speed signal traces, with which a well-defined ground-plane current path is desired.

By way of clarification, a typical low-cost package may have vias drilled through all layers of the package substrate. These vias are typically large and may leave behind a Swiss -cheese hole pattern in the ground and power plane layers. Cost savings may be especially obtainable for micro-via technologies, which use laser-drilled vias, as the cost of these substrates tends to be related to the number of laser-drilled vias required. The reduction in number of vias may be a direct result of using the bond wire as a combination routing/via layer. Accordingly, th e bond wires may effectively serve as vias passing through the top dielectric layer. Consequently, a substrate in accordance with the preferred embodiments may contribute to less expensive semiconductor devices.

As the signal metal 402 in the preferred embodiments is not disposed directly under the die 410 on the *n* metal layer 440, greater routing flexibility can be achieved. Referring briefly back to Figure 1B, in conventional substrate designs, bond wires 152 attach to substrate bond pads 156, from which signal traces 160 route out towards the perimeter of the substrate 120. This configuration may be acceptable for lower pin -count substrates, but as semiconductor dies increase in complexity, the need rises to package dies with ever-increasing pin-counts into smaller packages. Unlike the "depopulated-array" substrate 120 shown in Figure 1B, in which solder balls 164 are only located on the substrate periphery, many substrates are designed as "full arrays substrates. In full - array substrates, an array of solder balls is distributed over the entire area of the substrate.

Routing a die to solder balls on full -array substrates is often a challenge. Compounding this challenge is the fact that many of today's semiconductor package assemblies utilize chip -scale package (CSP) technology, in which the die has nearly the same area as the package substrate. To reach inner balls, the need may exist to route signals under the footprint of the die itself. In a conventional substrate, this may require routing sign al traces immediately underneath the die on the *n* metal layer, an area of particularly high stress. A package substrate in accordance with the preferred embodiments reduces the risk associated with routing the signal layer immediately under the die footpr int, by the placement of the signal layer on the *n-1* layer or below.

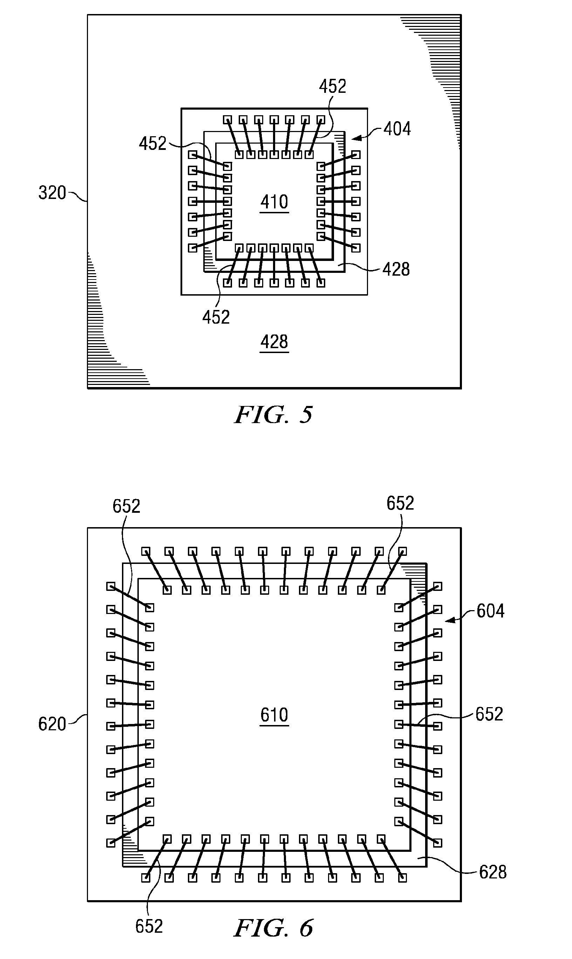

The substrate of the preferred embodiments can be used with a variety of technologies. Although it can be used with CSP packages, it also affords benefits to conventional non -CSP package assemblies. As previously mentioned, pin -counts tend to increase on newer, more complex dies. Meanwhile, the demand for smaller electronics-and consequently, smaller dies-continues to grow. Thus, a substrate design that contributes flexibility to rout ing options is preferred. Figure 5 shows a simplified top view of the preferred embodiment shown in Figure 4. Bond wires 452 bonded to the die 410 pass through a substrate bond opening 404 in the solder mask layer 428 and dielectric layer (not shown), affixing to exposed signal traces (also not shown) on the *n-1* metal layer below. As the opening 404 is disposed substantially midway between the center and periphery of the substrate 320, it would be relatively easy to use the space both outward and inward of the opening to route the signals through subsequent metal layers (not shown) and down to the solder balls (not shown).

Figure 6 shows a simplified top view of an alternative embodiment, in which the substrate bond opening 604 is disposed toward the periphery of the substrate 620. This alternative embodiment allows a much larger die 610, relative to the package footprint, to be bonded to the substrate 620. Bond wires 652 can then be passed through the opening 604 and affixed to the exposed signal metal. It will be understood that the various design options (e.g., substrate bond opening placement, signal layer location) discussed herein may be combined, without departing from the spirit of the invention. Further, the embodiments discussed herein have been illustrated utilizing a four-metal-layer (or "four-layer") substrate, but substrates with fewer or more metal layers may benefit from the configuration of the preferred embodiments, as well.

The above discussion is meant to be illustrative of the principles and various embodiments of the present invention. Numerous variations and modifications will become apparent to those skilled in the art once the above disclosure is fully appreciated. It is intended that the following claims be interpreted to embrace all such variations and modifications.

## Claims

1. A semiconductor package substrate comprising:
a first metal layer;
an underlying metal layer; and
a dielectric layer between the first metal layer and the underlying metal layer, wherein the underlying metal layer is adapted to forming an electrical connection with a semiconductor die by a bond wire.

2. The semiconductor package substrate of claim 1, wherein the underlying metal layer comprises a signal layer and the first me tal layer comprises a ground plane.

3. A method for assembling a semiconductor die onto a package substrate, the method comprising:
attaching the die over a first metal layer of the substrate; and
wire-bonding the die to an underlying metal layer of the substrate.

4. The method of claim 3, further comprising exposing a portion of the underlying metal layer by removing a portion of the first metal layer.

5. The method of claim 3 or claim 4, further comprising attaching a solder ball to the substrate.

6. A packaged semiconductor device comprising:
an integrated circuit die; and
a package substrate including a first metal layer and a underlying metal layer separated by a dielectric layer;
wherein the first metal layer is adapted to receiving the integrated circuit die, and the underlying metal layer is adapted to making electrical connection to the integrated circuit by wire - bonding.
